# EUROPEAN PATENT APPLICATION

(11) **EP 2 941 093 A1**
(43) Date of publication of application: **04.11.2015**
(21) Application number: 13867923.8
(22) Date of filing: 17.12.2013
(51) Int. Cl.: H05B 33/04, H01L 51/50, H05B 33/02, H05B 33/06, H05B 33/10

(54) **ORGANIC ELECTROLUMINESCENT PANEL AND ORGANIC ELECTROLUMINESCENT PANEL MANUFACTURING METHOD**

(30) Priority: 27.12.2012 JP 2012285538
(71) Applicant: Nitto Denko Corporation, Ibaraki-shi, Osaka 567-8680 (JP)
(72) Inventor: OSAKI, Yoshinori, Ibaraki-shi Osaka 567-8680 (JP); YAMAMOTO, Satoru, Ibaraki-shi Osaka 567-8680 (JP); KUWABARA, Shoujirou, Ibaraki-shi Osaka 567-8680 (JP)
(74) Representative: Grünecker Patent- und Rechtsanwälte PartG mbB
(86) International application number: PCT/JP2013/083712
(87) International publication number: WO 2014/103790

(57) **Abstract**

An organic electroluminescence panel 1 of the present invention includes a belt-shaped substrate 2, a plurality of organic electroluminescence elements 3 which is aligned and provided on the belt-shaped substrate 2 in a long direction of the belt-shaped substrate 2, and a plurality of sealing layers 4 which is provided on the organic electroluminescence elements 3, wherein each of the sealing layers 4 is independently provided on each of the plurality of organic electroluminescence elements 3, and adjacent sealing layers 4, 4 of the plurality of sealing layers do not contact each other.

## Description

### TECHNICAL FIELD

The present invention relates to an organic electroluminescence panel and a method of manufacturing the same.

### BACKGROUND ART

Hereinafter, the organic electroluminescence is referred to as the "organic EL".

An organic EL panel having a substrate, an organic EL element provided on the substrate, and a sealing layer provided on the organic EL element has hitherto been known. The organic EL element has a first electrode, a second electrode, and an organic layer provided between the both electrodes.

The organic EL element is typically used for illuminating devices, image displays, and the like.

A roll-to-roll method is known as the organic EL panel manufacturing method.

The roll-to-roll method is a manufacturing method of sequentially forming organic EL elements and sealing layers on a substrate while intermittently or continuously conveying a belt-shaped flexible substrate rolled in a roll state, and rolling the substrate in the roll state again.

As disclosed in Patent Document 1, the organic EL panel obtained by this roll-to-roll method includes a belt-shaped substrate, a plurality of organic EL elements aligned and provided on the belt-shaped substrate in a long direction, and a sealing layer provided on a plurality of organic EL elements.

In the organic EL panel disclosed in Patent Document 1, terminals of first electrodes and terminals of second electrodes are disposed on both sides of a short direction of the substrate, and the sealing layer is not provided on these terminals. Further, the sealing layer is provided to form a belt shape across a plurality of organic EL elements aligned in the long direction of the substrate.

Such an organic EL panel is an aggregate of a plurality of organic EL panels aligned on the substrate. Hence, the individual organic EL panels are taken out by cutting the substrate at boundary portions of the adjacent organic EL elements.

However, in the organic EL panel disclosed in Patent Document 1, the sealing layer is provided across a plurality of organic EL elements. Hence, the sealing layer is also cut when the substrate is cut at the boundary portion of the adjacent organic EL elements as described above.

When the substrate is cut together with the sealing layer, impact caused by cutting is applied to the sealing layer, and therefore an edge of the sealing layer at the cut portion (the edge of the sealing layer produced by cutting) slightly floats from the substrate in some cases.

When the sealing layer floats in this way and then a gap is produced between the sealing layer and the substrate, moisture or oxygen enters the organic layer from this gap. Hence, there is a problem that the organic EL panel is likely to deteriorate and a product lifetime shortens.

Further, when shapes of the organic EL elements seen from a plan view are formed in rectangular shapes whose long sides correspond to the long direction of the substrate in the organic EL panel disclosed in Patent Document 1, the following problem occurs.

That is, when the terminals of the first electrode and the second electrode are disposed at both end sides of the short direction of the substrate in the organic EL panel including the organic EL elements of the rectangular shapes, a rate of an area which an area of the terminals occupies in an area of one organic EL panel becomes large.

In other words, the terminals of the first electrode and the second electrode are disposed along the long direction of the substrate in the organic EL panel disclosed in Patent Document 1. The terminal of the first electrode is disposed along the long side of the organic EL element of the rectangular shape whose long side corresponds the long direction of the substrate, and the terminal of the second electrode is disposed along the other long side. Upon comparison of an area of the terminals disposed along the long sides and an area of the terminals disposed along the short sides, it is found that the former area is larger. When a rate of the area which the terminals occupy is large, a rate of an area which a light emission area occupies in the area of the organic EL panel becomes small to the contrary. For this reason, when the shapes of the organic EL elements seen from a plan view are formed in rectangular shapes whose long sides correspond to the long direction of the substrate in the organic EL panel disclosed in Patent Document 1, there is a problem that the rate of the area which the light emission area occupies becomes small.

[Patent Document 1] JP 2010-097803 A

### SUMMARY OF THE INVENTION

A first object of the present invention is to provide an organic EL panel which does not shorten a product lifetime even when individual EL panels are cut and taken out and a manufacturing method thereof.

A second object of the present invention is to provide an organic EL panel which can secure a relatively large light emission area.

An organic EL panel of the present invention includes a belt-shaped substrate, a plurality of organic EL elements which is aligned and provided on the belt-shaped substrate in a long direction of the belt-shaped substrate, and a plurality of sealing layers which is provided on the organic EL elements, wherein each of the sealing layers is independently provided on each of the plurality of organic EL elements, and adjacent sealing layers of the plurality of sealing layers do not contact each other.

In a preferable organic EL panel according to the present invention, each of the plurality of organic EL elements includes a first electrode which includes a terminal, a second electrode which includes a terminal, and an organic layer which is provided between the first electrode and the second electrode, the terminal of the first electrode is disposed at at least one side in a long direction of the substrate based on the organic layer, and the terminal of the second electrode is disposed at at least an opposite side in the long direction of the substrate to the terminal of the first electrode, and each of the sealing layers is provided on each of the organic EL elements except for the terminal of the first electrode and the terminal of the second electrode.

In a preferable organic EL panel according to the present invention, a length of each of the organic EL element corresponding to the long direction of the substrate is longer than a length of each of the organic EL element corresponding to a short direction of the substrate.

According to another aspect of the present invention, a method of manufacturing an organic EL panel is provided.

The method of manufacturing an organic EL panel includes an element forming step of forming in a long direction of a belt-shaped substrate a plurality of organic EL elements each including a first electrode, a second electrode, and an organic layer provided between the first electrode and the second electrode, and a sealing step of forming each of the independent sealing layers on each of the plurality of organic EL elements such that the sealing layers do not contact each other.

In a preferable method of manufacturing an organic EL panel according to the present invention, the element forming step includes disposing a terminal of the first electrode at at least one side in a long direction of the substrate based on the organic layer, and disposing a terminal of the second electrode at at least an opposite side in the long direction of the substrate to the terminal of the first electrode, and the sealing step includes forming each of the sealing layers on each of the organic EL elements except for the terminal of the first electrode and the terminal of the second electrode.

In a preferable method of manufacturing an organic EL panel according to the present invention, each of the sealing layers includes a sealing film, and an adhesive layer which is provided on a back surface of the sealing film and can make the sealing film be attached to each of the organic EL elements, and the sealing step includes repeatedly attaching one of the sealing films to one of the organic EL elements aligned in the long direction.

In the organic EL panel according to the present invention, a plurality of organic EL elements is aligned and provided on a belt-shaped substrate in a long direction of the belt-shaped substrate, and, further, each of sealing layers is provided on each of a plurality of organic EL elements and the adjacent sealing layers do not contact each other. This organic EL panel can be cut at boundary portions of organic EL elements without contacting the sealing layers. Consequently, the individual organic EL panels can be taken out without edges of the sealing layers being floated. Consequently, the present invention can provide an organic EL panel whose the sealing layers can reliably seal the organic EL elements, and which has a long product lifetime.

Further, the preferable organic EL panel according to the present invention has a long product lifetime as described above, and can also secure a large rate of an area which a light emission area occupies.

### BRIEF DESCRIPTION OF THE DRAWINGS

Fig. 1 is a plan view of an organic EL panel according to one embodiment of the present invention.
Fig. 2 is an enlarged sectional view taken along the line II-II in Fig. 1 (an enlarged sectional view cut in the long direction of an organic EL panel).
Fig. 3 is an enlarged sectional view taken along the line III-III in Fig. 1 (an enlarged sectional view cut in the short direction of an organic EL panel).
Fig. 4 is a plan view of an organic EL panel according to another embodiment of the present invention.
Fig. 5 is an enlarged sectional view of an organic EL panel according to further and another embodiment of the present invention cut in a long direction of an organic EL panel.
Fig. 6 is a plan view of an organic EL panel according to further and another embodiment of the present invention.
Fig. 7 is a plan view of a separator-attached sealing film according to one embodiment.
Fig. 8 is an enlarged sectional view taken along the line VIII-VIII in Fig. 7 (an enlarged sectional view of a separator-attached sealing film cut in a long direction).
Fig. 9A is a side view of a belt-shaped laminated body used to manufacture a separator-attached sealing film. Fig. 9B is a plan view of the belt-shaped laminated body.
Fig. 10 is an enlarged sectional view of a separator-attached sealing film according to another embodiment cut in a long direction.
Fig. 11 is a schematic side view of a sealing film attaching apparatus for performing a sealing step.

Hereinafter, the present invention will be described with reference to the drawings. It should be noted that dimensions such as a layer thickness and a length in the drawings are different from actual dimensions.

In this specification, the terms "first" and "second" may be added as prefixes. These prefixes, however, are only added in order to distinguish the terms and do not have specific meaning such as order and relative merits. The "belt shape" means a substantially rectangular shape in which a length in one direction is sufficiently longer than a length in the other direction. For example, the "belt shape" is a substantially rectangular shape in which a length in one direction is 10 times or more, preferably 30 times or more, more preferably 100 times or more of a length in the other direction. The "long direction" is one direction of the belt shape (direction parallel to the longer side of the belt shape), and the "short direction" is the other direction of the belt shape (direction parallel to the shorter side of the belt shape). The "planar shape" refers to a shape of a substrate surface seen from a vertical direction. A term "PPP to QQQ" means "PPP or more and QQQ or less".

### [Configuration of Organic EL Panel]

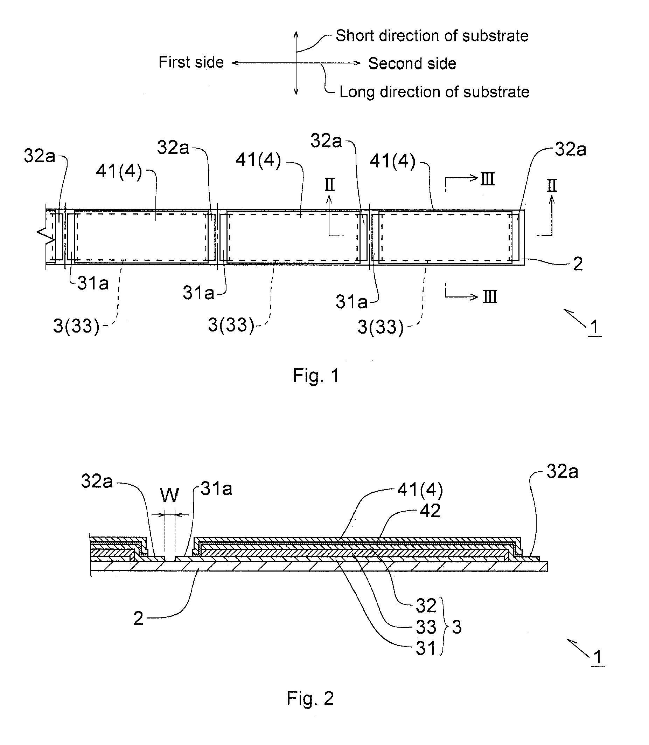

As illustrated in Fig. 1 to Fig. 3, an organic EL panel 1 according to one embodiment of the present invention includes a belt-shaped substrate 2, a plurality of organic EL elements 3 which is aligned and provided on the belt-shaped substrate 2 in a long direction of the belt-shaped substrate, and sealing layers 4 which are provided on the organic EL elements 3.

The organic EL elements 3 include a first electrode 31 which includes a terminal 31a, a second electrode 32 which includes a terminal 32a, and an organic layer 33 which is provided between the first electrode 31 and the second electrode 32.

In each of the organic EL elements 3, the terminal 31a of the first electrode 31 is disposed at one side (a first side) in a long direction based on the organic layer 33, and the terminal 32a of the second electrode 32 is disposed at an opposite side in the long direction of the substrate to the terminal of the first electrode. It can be said that the second electrode 32a is provided at a second side in the long direction based on the organic layer 33. The first side and the second side in the long direction are opposite to each other, and when referring to Fig. 1, the first side in the long direction is the left side of the long direction and the second side in the long direction is the right side.

The sealing layer 4 is provided on the organic EL elements 3 so as to cover a surface of each organic EL element 3 except for the terminals 31a and 32a.

The organic EL elements 3 are disposed in one row in a short direction of the substrate 2, and a plurality of organic EL elements 3 is aligned spaced predetermined intervals apart in the long direction of the substrate 2. The portions corresponding to these intervals are boundary portions of the adjacent organic EL elements 3. Hence, the respective organic EL elements 3 are not continuous, and independent from each other.

The organic EL panel 1 of the present invention is also an aggregate of organic EL panels 1 in which a plurality of organic EL panels is provided in series in the long direction by means of the belt-shaped substrate 2.

By cutting the aggregate of organic EL panels at a boundary portion between adjacent organic EL elements 3, individual organic EL panels can be taken out.

The plane shape of the substrate 2 is a belt shape.

A length of the belt shape of the substrate 2 (length in a long direction) is not particularly limited, but it is 10m to 1000m, for example. Furthermore, a width of the substrate 2 (length in a short direction) is not particularly limited, but for example, it is 10mm to 300mm, preferably 10mm to 100mm. A thickness of the substrate 2 is also not particularly limited, and it is appropriately designed in consideration of the material thereof. When a metal substrate or a synthetic resin substrate is used as the substrate 2, the thickness thereof is 10 µm to 50 µm, for example.

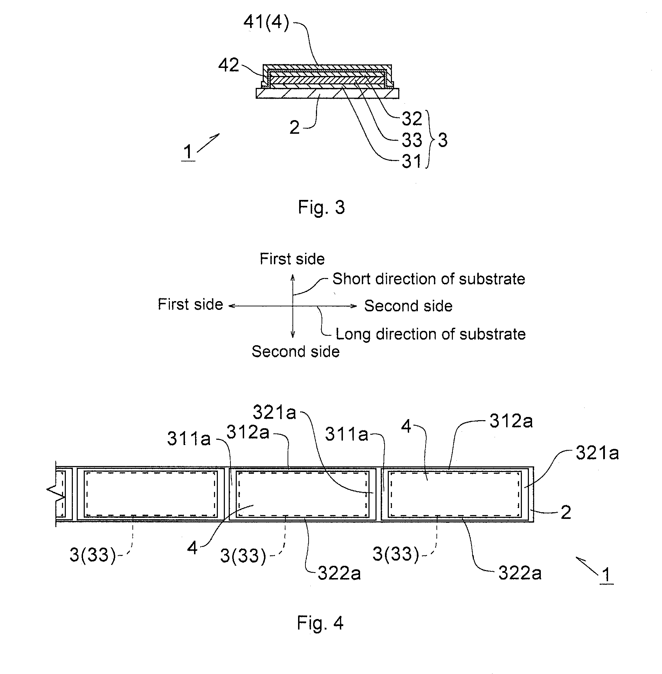

As illustrated in Fig. 2 and Fig. 3, a layer configuration of one organic EL panel 1 is a laminate structure including a substrate 2, a first electrode 31 provided on the substrate 2, an organic layer 33 provided on the first electrode 31, a second electrode 32 provided on the organic layer 33, and a sealing layer 4 provided on the second electrode 32.

When the substrate 2 has electric conductivity, an insulating layer (not illustrated) is provided between the substrate 2 and the first electrode 31 in order to prevent an electrical short-circuit.

A length of the organic EL element 3 corresponding to the long direction of the substrate 2 is longer than a length of the organic EL element 3 corresponding to the short direction of the substrate 2. In the illustrated example, the plane shape of the organic EL element 3 is a substantially rectangular shape having a longer side in the long direction and a shorter side in the short direction of the substrate 2. The length of the long side of the organic EL element 3 is not particularly limited, but for example, it is 1.5 times to 20 times and preferably 2 times to 15 times the length of the short side.

However, the organic EL element 3 does not necessarily have a substantially rectangular shape, but may have, for example, a substantially elliptical shape which is long in the long direction of the substrate 2 (not illustrated). In the organic EL panel 1 of the present invention, the organic EL element 3 does not necessarily have a shape in which a length corresponding to the long direction of the substrate 2 is longer than a length corresponding to the short direction of the substrate 2. For example, the present invention also includes the organic EL panel in which the shape of the organic EL element 3 in plan view is a substantially square or circular shape (not illustrated).

The organic layer 33 of the organic EL element 3 includes a light emitting layer, and has various kinds of functional layers such as a positive hole transport layer and an electron transport layer, as necessary. The layer configuration of the organic layer 33 is described later.

For forming the terminal 31a of the first electrode 31, the organic layer 33 is provided on the first electrode 31 except for the end portion (terminal 31a) of the first electrode 31 on the first side in the long direction.

Although the second electrode 32 is provided on the organic layer 33 so as to cover a surface of the organic layer 33, for forming the terminal 32a of the second electrode 32, the end portion (terminal 32a) of the second electrode 32 is drawn from the end portion of the organic layer 33 to the second side in the long direction.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

In the examples in Figs. 1 to 3, planar shapes of the terminals 31a and 32a of the first electrode 31 and the second electrode 32 have substantially rectangular shapes extending along the short direction of the substrate 2. In this regard, the planar shapes of the terminals 31a and 32a are not limited to the substantially rectangular shapes extending in the short direction, and may have shapes such as a square shape, an arc shape or a spot shape, for example.

In addition, in the examples in Figs. 1 to 3, the terminals 31a of the first electrodes 31 are disposed at a first side in a long direction, and the terminals 32a of the second electrode 32 are disposed at a second side in the long direction. However, the present invention is not limited to this configuration. As illustrated in, for example, Fig. 4, terminals 311a and 312a of the first electrode 31 may be disposed at the first side in the long direction and a first side in a short direction of the substrate 2, and terminals 321a and 322a of the second electrode 32 may be disposed at the second side in the long direction and a second short direction side of the substrate 2. In this case, as illustrated in Fig. 4, each sealing layer 4 may be provided on each organic EL element 3 except for the terminals 311a, 312a, 321a and 322a. Alternatively, similar to the above-described embodiment, although not illustrated, each sealing layer 4 may be provided on each organic EL element 3 except for the terminal 311a of the first electrode 31 at the first side in the long direction and the terminal 321a of the second electrode 32 at the second side in the long direction.

Back to Figs. 1 to 3, the electrodes of the adjacent organic EL elements 3 do not contact each other and include a slight gap W therebetween. That is, there is a boundary portion of the adjacent organic EL elements 3 between an edge of the first electrode 31 of one organic EL element 3 and an edge of the second electrode 32 of the adjacent organic EL element 3. There is the gap W which does not include an electrode at this boundary portion, and there is only the substrate 2 in this gap W. By cutting the substrate 2 at this boundary portion (gap W), it is possible to take out the individual organic EL panels 1 without applying impact to the electrodes 31 and 32, the sealing layers 4 and the like.

The length of the gap W is not particularly limited yet is preferably the same as or is longer than the thickness of a cutting tool. By setting the length of the gap W to the same as or longer than the thickness of a cutting tool, only the substrate 2 can be cut by the cutting tool without grinding the edge of the first electrode 31 or the edge of the second electrode 32 when the substrate 2 is cut along the boundary portion by using the cutting tool.

For example, the length of the gap W is 0.5 mm or more and is preferably 1 mm or more. Meanwhile, when the length of the gap W is too long, the number of organic EL elements 3 which can be formed on one substrate 2 decreases. From this point of view, the length of the gap W is preferably 5 mm or less and is more preferably 3 mm or less.

In this regard, the electrodes of the adjacent organic EL elements 3 may contact or overlap each other (not illustrated). This is because the present invention can prevent the sealing layer 4 from being peeled off upon cutting since the sealing layers 4 are not provided at the boundary portions of the adjacent organic EL elements 3.

The sealing layer 4 is independently provided on the surface of each organic EL element 3 (second electrode 32) without covering the terminals 31a and 32a of the first electrode 31 and the second electrode 32. The adjacent sealing layers 4 and 4 do not contact each other (are placed in a non-contact state).

As described above, the sealing layers 4 are not provided at the boundary portions of the adjacent organic EL elements 3. Hence, as illustrated in Fig. 1, non-sealing regions which do not include the sealing layers 4 and extend fully in the short direction are intermittently provided on the surface of the substrate 2 in the long direction.

In other words, the sealing layer 4 is not provided across the adjacent organic EL elements 3, and one sealing layer 4 is provided on one organic EL element 3. Hence, each sealing layer 4 is independent, and is provided spaced a predetermined interval apart in the long direction of the substrate 2.

The sealing layer 4 is a layer which prevents oxygen and moisture from entering the organic EL element 3.

The sealing layer 4 covers the entire organic EL element 3 in an airtight manner except for the terminals 31a and 32a. More specifically, the sealing layer 4 is closely attached to the surface of the second electrode 32 except for the terminals 31a and 32a, and is further closely attached to both lateral portions of the organic EL element 3 as illustrated in Fig. 3. Further, a circumference portion of the sealing layer 4 is adhered to the surface of the substrate 2, the surface of the first electrode 31, and the surface of the second electrode 32.

Each sealing layer 4 may be formed by a sealing film, may be formed by a resin coating film formed by coating the organic EL element with synthetic resin or may be formed by an inorganic material such as a nitride.

In the present embodiment, the sealing layer 4 is formed by a sealing film 41. This sealing film 41 is adhered to the organic EL element 3, and therefore, as illustrated in Figs. 2 and 3, an adhesive layer 42 which can make the sealing film 41 be attached to the organic EL element 3 is provided on the back surface of the sealing film 41. The sealing layer 4 is adhered to the organic EL element 3 through the adhesive layer 42.

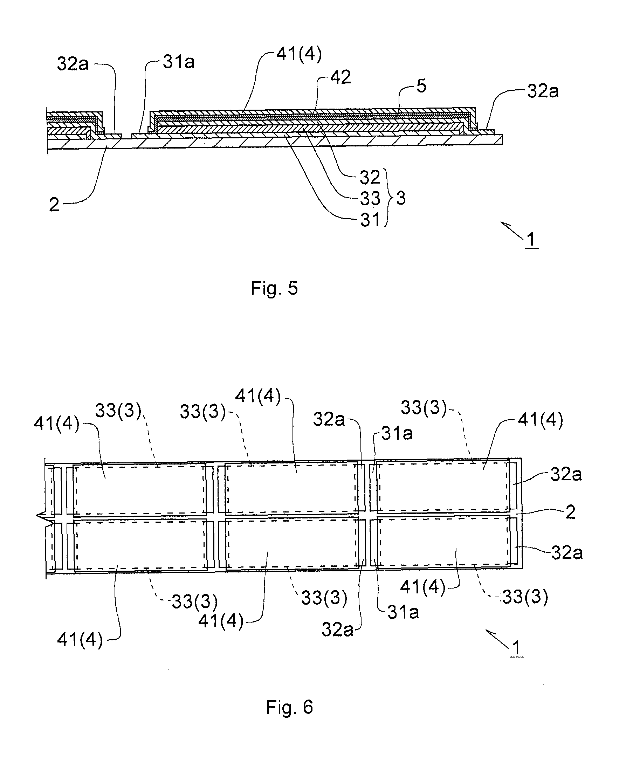

In addition, as illustrated in Fig. 5, a barrier layer 5 may be provided under the sealing layer 4 when necessary. The barrier layer 5 is provided on the surface of the second electrode 32, and the sealing layer 4 is provided on this barrier layer 5.

Further, the organic EL panel 1 according to the present invention is not limited to a configuration where the organic EL elements 3 are disposed in one row in the short direction of the substrate 2, and may employ a configuration where the organic EL elements 3 are disposed in a plurality of rows in the short direction of the substrate 2. As illustrated in, for example, Fig. 6, the present invention includes the organic EL panel 1, too, in which the organic EL elements 3 are disposed in two rows in the short direction of the substrate 2.

By cutting the organic EL panel 1 according to the present invention along the boundary portions of the organic EL elements 3 by using the cutting tool (cutting lines are indicated as dashed-dotted lines in Fig. 1), the organic EL panel 1 can be separated to an individual organic EL panel.

A cutting method which uses the cutting tool includes cutting performed by using a blade of a knife edge shape, mechanical cutting such as cutting performed by using a rotary blade or cutting performed by irradiation of laser beams.

The organic EL panel 1 according to the present invention includes the sealing layers 4 independently provided on a plurality of organic EL elements 3, respectively, and the adjacent sealing layers 4 and 4 do not contact each other. In this organic EL panel 1, cutting can be performed to cut the substrate 2 at boundary portions of organic EL elements 3 without contacting the sealing layers 4. Consequently, edges of the sealing layers 4 do not float upon cutting, and the individual organic EL panels can be taken out.

Consequently, the present invention can provide an organic EL panel whose sealing layers 4 can reliably seal the organic EL elements 3, and which has a long product lifetime.

Particularly, according to the organic EL panel 1 of the present invention, the terminals 31a of the first electrodes 31 are disposed at the first side in the long direction and the terminals 32a of the second electrode 32 are disposed at the second side in the long direction, and each sealing layer 4 is provided on each organic EL element 3 except for the surface of each of the terminals 31a and 32a. Consequently, this organic EL panel can be cut at boundary portions of organic EL elements 3 without contacting the organic EL elements 3 and the sealing layers 4.

Further, according to the organic EL panel 1 of the present invention, the terminals 31a of the first electrode 31 are disposed at the first side in the long direction, and the terminals 32a of the second electrode 32 are disposed at the opposite side of the first side in the long direction. Consequently, when the length of the organic EL element 3 corresponding to the long direction of the substrate 2 is formed longer than the length corresponding to the short direction of the substrate 2, it is possible to obtain the organic EL panel 1 whose rate of an area (a planar shape area) of the organic layers 33 is large. This organic EL panel 1 has a large rate of an area which a light emission area occupies in the area of the organic EL panel.

An organic EL panel 1 of the present invention can be used as a light emitting panel such as an illuminating device, an image display, and the like. A formation material of the organic EL panel 1 is specifically explained below.

### (Belt-Shaped Substrate)

For a belt-shaped substrate, a flexible substrate can be used, for example. The flexible substrate is a flexible sheet-shaped material that can be wound in the form of a roll.

The substrate may be either transparent or opaque. When a bottom emission type organic EL panel is formed, a transparent substrate is used.

In this specification, the index of transparency may be, for example, a total light transmittance of 70% or more, preferably 80% or more. It is to be noted that the total light transmittance is a value measured by a measurement method conforming to JIS K7105 (Method of Testing Optical Characteristics of Plastics).

While a material of the substrate is not particularly limited, examples thereof include a glass substrate, a metal substrate, a synthetic resin substrate, and a ceramic substrate. Examples of the synthetic resin substrate include a flexible synthetic resin film such as that of a polyester-based resin such as polyethylene terephthalate (PET), polyethylene naphthalate (PEN), and polybutylene terephthalate (PBT); an olefin-based resin having an α-olefin as a monomer component, such as polyethylene (PE), polypropylene (PP), polymethylpentene (PMP), ethylene-propylene copolymers, and an ethylene-vinyl acetate copolymer (EVA); polyvinyl chloride (PVC); a vinyl acetate-based resin; polycarbonate (PC); polyphenylene sulfide (PPS); an amide-based resin such as polyamide (nylon) and wholly aromatic polyamide (aramid); a polyimide-based resin; and polyether ether ketone (PEEK). Examples of the metal substrate include a flexible thin plate formed of stainless steel, copper, titanium, aluminum, and alloys.

For preventing a rise in temperature of the organic EL panel at the time of driving, the substrate is preferably excellent in heat dissipation. For preventing infiltration of oxygen and water vapor into the organic EL panel, the substrate preferably has gas and water vapor barrier properties.

When a metal substrate is used, an insulating layer is provided on a surface of the metal substrate in order to insulate the substrate against an electrode formed on the surface thereof.

### (First Electrode of Organic EL Element)

A first electrode is an anode, for example.

A formation material of the first electrode (anode) is not particularly limited, but examples include indium tin oxide (ITO); indium tin oxide including silicon oxide (ITSO); aluminum; gold; platinum; nickel; tungsten; copper; and an alloy. When a bottom emission type organic EL panel is formed, a transparent first electrode is used. A thickness of the first electrode is not particularly limited, but it is usually 0.01 µm to 1.0 µm

### (Organic Layer of Organic EL Element)

An organic layer is a laminated body composed of at least two layers. Examples of a structure of the organic layer include (A) a structure composed of three layers including a positive hole transport layer, a light emitting layer, and an electron transport layer; (B) a structure composed of two layers including a positive hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer works as a positive hole transport layer.

The organic layer used in the present invention can have any of the structures (A) to (C) mentioned above.

The organic layer having the structure (A) is explained below.

The positive hole transport layer is provided on the surface of the first electrode. An arbitrary function layer other than the first electrode and the positive hole transport layer may be interposed between the first electrode and the positive hole transport layer under the conditions in which the light emitting efficiency of the organic EL element is not lowered.

For example, the positive hole injection layer is provided on the surface of the first electrode, and the positive hole transport layer may be provided on the surface of the positive hole injection layer. The positive hole injection layer is a layer having a function of aiding injection of a positive hole from the anode layer to the positive hole transport layer.

A formation material of the positive hole transport layer is not particularly limited as long as the formation material has a positive hole transport function. Examples of the formation material of the positive hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N'-bis(naphthalene-1-yl)-N,N'-bis(phenyl)-9,9'-spiro-bisfluorene (abbreviation: Spiro-NPB); a polymer compound; and the like. The formation material of the positive hole transport layer may be used alone or in combination of two or more types. Furthermore, the positive hole transport layer may be a multi-layer structure having two or more layers.

A thickness of the positive hole transport layer is not particularly limited, but the thickness of 1 nm to 500 nm is preferable from the viewpoint of reducing drive voltage.

A light emitting layer is provided on the surface of the positive hole transport layer.

A formation material of the light emitting layer is not particularly limited as long as it has light emitting property. Examples of the formation material of the light emitting layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2- [2- [4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (Alq₃), and the like.

Furthermore, as the formation material of the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) (Ir(ppy)₃), tris(1-phenyl isoquinoline)iridium (III) (Ir(piq)₃), and bis(1-phenyl isoquinoline) (acetylacetonato) iridium (III) (abbreviation: Ir(piq)₂(acac)), and the like.

Furthermore, the formation material of the light emitting layer may include such as the formation material of the positive hole transport layer mentioned above, the formation material of the electron transport layer mentioned below, and various additives.

A thickness of the light emitting layer is not particularly limited, but the thickness of 2 nm to 500 nm is preferable, for example.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer is provided on the surface of the electron transport layer, and the second electrode 32 is provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used alone or in combination of two or more types. Furthermore, the electron transport layer may have a multi-layered structure composed of two or more layers.

A thickness of the electron transport layer is not particularly limited, but the thickness of 1 nm to 500 nm is preferable from the viewpoint of reducing drive voltage.

### (Second Electrode of Organic EL Element)

A second electrode is a cathode, for example.

A formation material of the cathode is not particularly limited, but a transparent second electrode is used when a top emission type organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, but it is usually 0.01 µm to 1.0 µm.

### (Barrier Layer of Organic EL Element)

A barrier layer is provided for protecting the organic EL element and preventing infiltration of moisture and oxygen. While a formation material of the barrier layer is not particularly limited, but examples include a metal oxide film, an oxynitride film, a nitride film, and a carbide nitride oxide film. Examples of the metal oxide film include MgO, SiO, SiₓO_{y}, Al₂O₃, GeO, and Ti₂O. The barrier layer is preferably a silicon carbide nitride oxide film, a silicon oxynitride film, and a silicon nitride film.

A thickness of the barrier layer is not particularly limited, but it is 50 nm to 50 µm, for example.

### (Sealing Layer)

As a formation material of the sealing layer, a synthetic resin such as an ethylene tetrafluoroethylene copolymer (ETFE), high density polyethylene (HDPE), oriented polypropylene (OPP), polystyrene (PS), polymethyl methacrylate (PMMA), oriented nylon (ONy), polyethylene terephthalate (PET), polycarbonate (PC), polyimide, polyether sulfone (PES), or polyethylene naphthalate (PEN) can be suitably used. As the sealing layer, a metallic thin plate formed of stainless steel, copper, titanium, aluminum, or an alloy can also be used. For preventing infiltration of oxygen and water vapor into the organic EL panel, the sealing layer preferably has gas and water vapor barrier properties. As the formation material of the sealing layer, inorganic materials such as nitride can be used.

When a sealing film is used as the sealing layer, a film composed of the above-mentioned synthetic resin or a metallic thin plate can be used.

A thickness of the sealing film (such as a synthetic resin film and a metallic thin plate) is not particularly limited, but for example, it is 5 µm to 1 mm and preferably 10 µm to 500 µm.

The adhesive layer for adhering the sealing film to the organic EL element is formed from a known adhesive. It is preferred to use, for example, a thermosetting or photo-setting adhesive as the above-mentioned adhesive. The adhesive is adjusted to an appropriate viscosity, and provided on the back surface of the sealing film with a uniform thickness.

### [Organic EL Panel Manufacturing Method]

An organic EL panel manufacturing method at least includes: an element forming step of aligning and forming in the long direction of the belt-shaped substrate a plurality of organic EL elements each including a first electrode including a terminal, a second electrode including a terminal and an organic layer provided between the first electrode and the second electrode; and a sealing step of forming the sealing layers on a plurality of organic EL elements. In the element forming step, the terminal of the first electrode and the terminal of the second electrode are disposed at the first and second sides in the long direction of the substrate based on the organic layer. In the sealing step, the sealing layer is formed on the organic EL element except for the terminal of the first electrode disposed at the first side in the long direction of the substrate and the terminal of the second electrode disposed at the second side in the long direction.

Preferably, the organic EL panel 1 according to the present invention can be manufactured using a roll-to-roll method.

### (Element Forming Step)

The organic EL element forming step is performed in the same way as conventionally performed.

Briefly, the belt-shaped substrate rolled in a roll state is led out, the substrate is rinsed and then the first electrodes are formed on this substrate.

As the first electrode formation method, an optimum method can be employed depending on the formation material thereof, and examples of the method include a spattering method, a deposition method and an ink-jet method. When, for example, the first electrode is made of metal, the deposition method is used.

In addition, a substrate on which the first electrodes are patterned in advance may be used. When the substrate on which the first electrodes are patterned in advance is used, the substrate is led out from a roll and rinsed, and then the organic layers are formed on the first electrodes.

A positive hole transport layer, a light emitting layer, and an electron transport layer are formed in this order on the first electrode except for a terminal thereof.

As the formation method of the positive hole transport layer and the electron transport layer, an optimum method can be employed depending on the formation material thereof, and examples of the method include a sputtering method, a deposition method, an ink-jet method, a coating method, and the like.

As the formation method of the light emitting layer, an optimum method can be employed depending on the formation material thereof, but usually it is formed by a deposition method.

Subsequently, the second electrode is formed on the organic layer. The second electrode is formed so as not to cover the terminal of the first electrode. As the formation method of the second electrode, an optimum method can be employed depending on the formation material thereof, and examples of the method include a sputtering method, a deposition method, an ink-jet method, and the like.

In this way, a plurality of organic EL elements are formed at necessary intervals on the substrate. A state where the organic EL elements 3 have been formed on the substrate 2 is the same as a state where the sealing layers 4 (the sealing films 41 and the adhesive layers 42) are removed from Figs. 1 to 5, and therefore is not illustrated in particular.

After a plurality of organic EL elements is formed on the substrate, this substrate may be rolled in a roll state once, or the sealing layers may be continuously provided thereon.

### (Sealing Step)

In the sealing step, the sealing layers are formed on a plurality of organic EL elements without contacting each other.

The sealing layer is formed on the organic EL element except for the terminal of the first electrode disposed at the first side in the long direction of the substrate and the terminal of the second electrode disposed at the second side in the long direction.

The sealing layer formation method is not particularly limited. For example, the sealing layer may be formed on the organic EL element by coating a required area with a coating solution including synthetic resin, or may be formed by attaching the sealing film 41 onto the organic EL element.

The sealing layer can be relatively easily formed on the required area, and therefore using the sealing film is preferable.

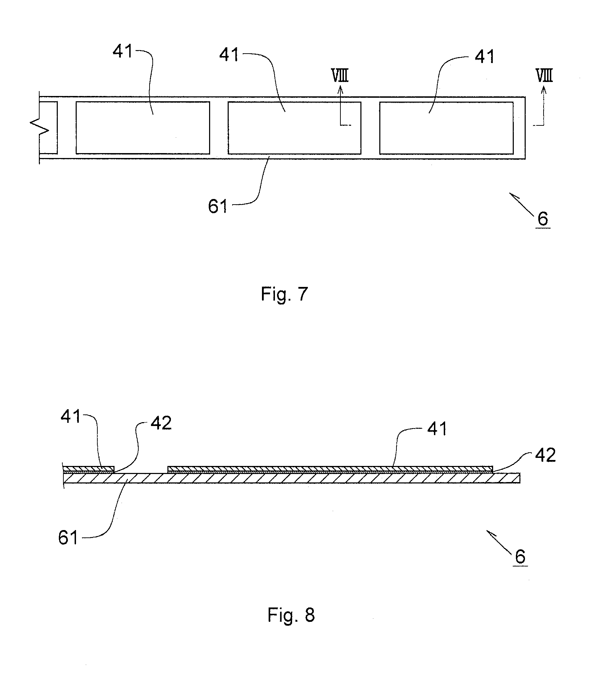

Figs. 7 and 8 illustrate examples of a laminated body 6 (separator-attached sealing film) used for the roll-to-roll method.

The adhesive layer 42 is provided on the back surface of the sealing film 41. The adhesive layer 42 is temporarily attached onto a separator 61.

A planar shape of the separator 61 is a belt-shape. A plurality of sealing films 41 is temporarily attached spaced predetermined intervals apart on the surface of this belt-shaped separator 61.

One sealing film 41 is attached to cover the organic layer of one organic EL element except for the terminal of the first electrode and the terminal of the second electrode. Therefore, the planar shape of the sealing film 41 is formed into a similar figure a little larger than a planar shape of the organic layer.

The laminated body 6 formed by attaching a plurality of these sealing films 41 spaced an interval apart on the separator 61 can be easily obtained as follows.

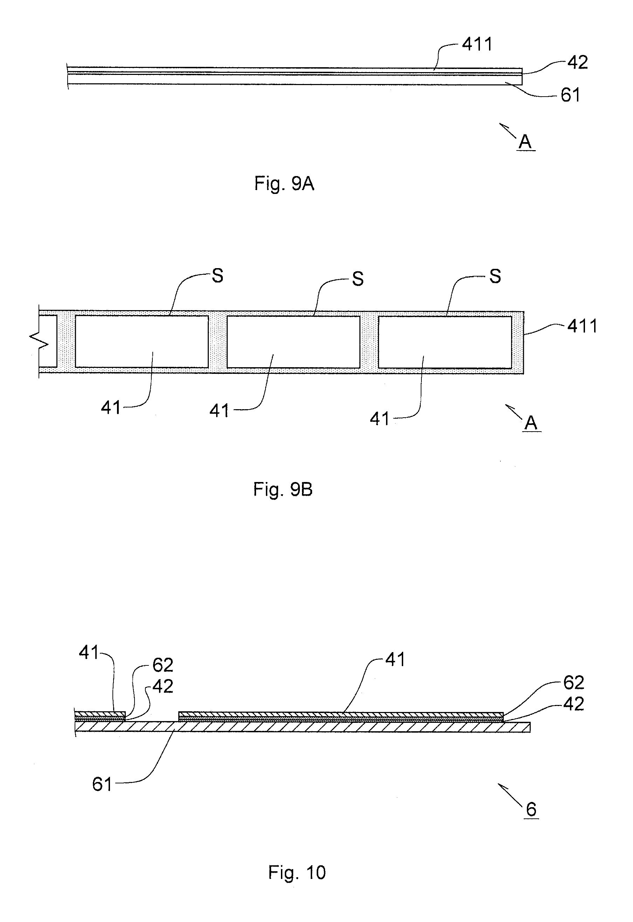

First, as illustrated in Fig. 9A, a belt-shaped laminated body A including the belt-shaped separator 61 and a belt-shaped original sealing film 411 laminated through the adhesive layer 42 on the belt-shaped separator 61 is prepared.

Only the original sealing film 411 (and the adhesive layer 42) is cut into a predetermined shape from above this belt-shaped laminated body A. Fig. 9B illustrates cut lines S obtained by cutting. By forming the cut lines S and S at predetermined intervals, a plurality of sealing films 41 is formed in the plane of the original sealing film 411. Areas partitioned by the cut lines S are the individual sealing films 41. Further, by removing portions other than the areas partitioned by the cut lines S, from the separator 61, it is possible to obtain the laminated body 6 illustrated in Figs. 7 and 8. In addition, an infinite number of dots are added to the portions to be removed (the portions other than the areas partitioned by the cut lines S) in Fig. 9B.

As the formation material of the sealing film 41, those shown above as an example are used.

As the separator 61, a sheet-shaped article having a surface subjected to a mold releasability imparting treatment so that the adhesive layer 42 is easily peeled off is used. The formation material of the separator 61 is not particularly limited, and examples thereof include a synthetic resin film, a synthetic paper, and a paper subjected to a mold releasability imparting treatment.

In addition, as illustrated in Fig. 10, a barrier layer 62 may be provided under the sealing film 41 when necessary. The barrier layer 62 is provided to the back surface of the sealing film 41, and the adhesive layer 42 is provided on the back surface of this barrier layer 62. The same barrier layer as that of the organic EL element can be used for the barrier layer 62.

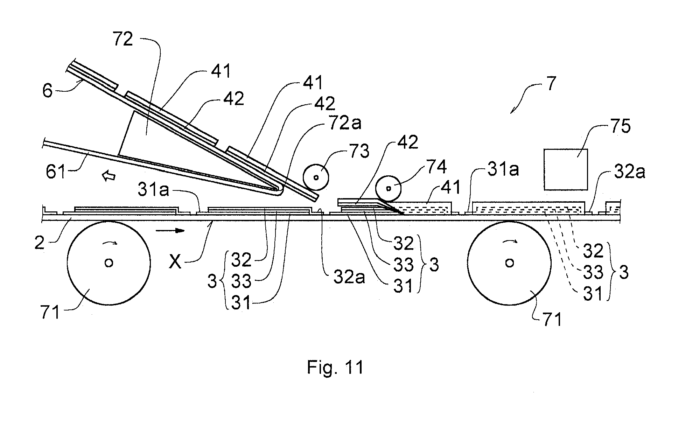

The sealing films 41 are attached to an organic EL element-formed substrate X obtained in the element forming step while the organic EL element-formed substrate X is conveyed to a downstream side as illustrated in Fig. 11.

Fig. 11 is a schematic side view of a sealing film attaching apparatus.

An attaching apparatus 7 includes convey rollers 71 which convey in the long direction the organic EL element-formed substrate X, a peel plate 72 which separates the separator 61 and the sealing film 41, a guide roller 73 which is provided at a front end portion 72a of the peel plate 72, convey collection rollers (not illustrated) which convey the laminated body 6 (separator-attached sealing film) to the peel plate 72 and collects the separator 61, a pressing roller 74 which presses the surface of the sealing film 41 peeled from the separator 61, and curing device 75 which cures the adhesive layer 42 provided on the back surface of the sealing film 41.

The peel plate 72 is a plate-shaped body formed in the shape of an acute angled triangle in side view. The peel plate 72 is disposed such that the front end portion 72a (acute-angled portion) thereof is positioned in the vicinity of a surface of the organic EL element-formed substrate X. The distance between the front end portion 72a of the peel plate 72 and the surface of the organic EL element-formed substrate X is not particularly limited. Of course, when the above-mentioned distance is excessively small, the front end portion 72a of the peel plate 72 may come into contact with the surface of the organic EL element 3 to damage the surface of the organic EL element 3. On the other hand, when the above-mentioned distance is excessively long, the sealing film 41 peeled off by the peel plate 72 may not be transferred to the surface of the organic EL element 3. In view of these considerations, the distance between the front end portion 72a of the peel plate 72 and the surface of the organic EL element-formed substrate X is preferably 2 mm or more, more preferably 3 mm or more. The upper limit of the above-mentioned distance is, for example, 20 mm or less, preferably 10 mm or less although depending on a size of the sealing film 41.

The organic EL element-formed substrate X is conveyed to the long direction with the terminals 32a of the second electrodes 32 directed toward the downstream side. In the figure, solid arrows indicate conveying directions.

The laminated body is conveyed to the peel plate 72 in synchronization with conveyance of the organic EL element-formed substrate.

In addition, the laminated body 6 may be continuously conveyed or may be intermittently conveyed by way of segment conveyance of the length of one sealing film.

At the front end portion 72a of the peel plate 72, only the separator 61 is turned around and collected. In the figure, the void arrow shows a direction in which the separator 61 is collected.

As the separator 61 is turned around at the front end portion 72a of the peel plate 72, interlayer peeling occurs between the adhesive layer 42 and the separator 61, so that the sealing film 41 is separated from the separator 61 together with the adhesive layer 42.

The adhesive layer 42 comes into contact with the surface of the organic EL element to attach the sealing film 41 to the organic EL element 3. The sealing film 41 is attached while being appropriately aligned so as not to cover each of the terminals 31a and 32a.

The pressing roller 74 presses the sealing film 41 from above the sealing film 41 attached to the organic EL element 3, so that the circumference portion of the sealing film 41 is closely attached to the both lateral portions of the organic EL element.

Subsequently, the curing device 75 which is provided at the downstream side of the pressing roller 74 cures the adhesive layer 42, so that the sealing film 41 is fixed on the organic EL element 3 and sealing the organic EL element 3 is finished. An optimum device is used for the curing device 75 according to a type of an adhesive. A heating device is used for a thermal-curing adhesive, and a light irradiating device such as an ultraviolet lamp is used for a photo-curable adhesive.

Thus, by attaching one sealing film 41 to one organic EL element and repeating attaching one sealing film 41 to each of the organic EL elements aligned in the long direction of the substrate 2, it is possible to obtain the belt-shaped organic EL panel 1 illustrated in Figs. 1 to 3.

The organic EL panel of the present invention and the method of manufacturing thereof are not limited to the embodiments described above, and a design change may be appropriately made within a scope intended by the present invention.

### INDUSTRIAL APPLICABILITY

An organic EL panel of the present invention can be used for illuminating devices, image displays, or the like.

1 Organic EL panel, 2 Substrate, 3 Organic EL element, 31 First electrode, 31a, 311a, 312a Terminal of first electrode, 32 Second electrode, 32a, 321a, 322a Terminal of second electrode, 33 Organic layer, 4 Sealing layer, 41 Sealing film, 42 Adhesive layer, 61 Separator

## Claims

1. An organic electroluminescence panel comprising:
a belt-shaped substrate;
a plurality of organic electroluminescence elements which is aligned and provided on the belt-shaped substrate in a long direction of the belt-shaped substrate; and
a plurality of sealing layers which is provided on the organic electroluminescence elements, wherein
each of the sealing layers is independently provided on each of the plurality of organic electroluminescence elements, and
adjacent sealing layers of the plurality of sealing layers do not contact each other.

2. The organic electroluminescence panel according to claim 1, wherein
each of the plurality of organic electroluminescence elements includes
a first electrode which includes a terminal;
a second electrode which includes a terminal; and
an organic layer which is provided between the first electrode and the second electrode;
the terminal of the first electrode is disposed at at least one side in a long direction of the substrate based on the organic layer, and the terminal of the second electrode is disposed at at least an opposite side in the long direction of the substrate to the terminal of the first electrode, and
each of the sealing layers is provided on each of the organic electroluminescence elements except for the terminal of the first electrode and the terminal of the second electrode.

3. The organic electroluminescence panel according to claim 1 or 2, wherein a length of each of the organic electroluminescence element corresponding to the long direction of the substrate is longer than a length of each of the organic electroluminescence element corresponding to a short direction of the substrate.

4. A method of manufacturing an organic electroluminescence panel comprising:
an element forming step of forming in a long direction of a belt-shaped substrate a plurality of organic electroluminescence elements each including a first electrode, a second electrode, and an organic layer provided between the first electrode and the second electrode; and
a sealing step of forming each of the independent sealing layers on each of the plurality of organic electroluminescence elements such that the sealing layers do not contact each other.

5. The method of manufacturing the organic electroluminescence panel according to claim 4, wherein
the element forming step includes disposing a terminal of the first electrode at at least one side in a long direction of the substrate based on the organic layer, and disposing a terminal of the second electrode at at least an opposite side in the long direction of the substrate to the terminal of the first electrode, and
the sealing step includes forming each of the sealing layers on each of the organic electroluminescence elements except for the terminal of the first electrode and the terminal of the second electrode.

6. The method of manufacturing the organic electroluminescence panel according to claim 4 or 5, wherein
each of the sealing layers includes a sealing film, and an adhesive layer which is provided on a back surface of the sealing film and can make the sealing film be attached to each of the organic electroluminescence elements, and
the sealing step includes repeatedly attaching one of the sealing films to one of the organic electroluminescence elements aligned in the long direction.
